# EUROPEAN PATENT APPLICATION

(11) **EP 2 924 742 A1**
(43) Date of publication of application: **30.09.2015**
(21) Application number: 15161082.1
(22) Date of filing: 26.03.2015
(51) Int. Cl.: H01L 33/00

(54) **Light source system and optical coherence tomography apparatus using the light source system**

(30) Priority: 27.03.2014 JP 2014067025
(71) Applicant: Canon Kabushiki Kaisha, Tokyo 146-8501 (JP)
(72) Inventor: Uchida, Takeshi, Ohta-ku, Tokyo 146-8501 (JP); Yoshioka, Takeshi, Ohta-ku, Tokyo 146-8501 (JP)
(74) Representative: TBK

(57) **Abstract**

A light source system (160) includes a laminate having a lower electrode layer (120), an active layer (103) and an upper electrode layer (120) in this order, a light-emitting element (100) including at least one of the upper electrode layer and the lower electrode layer divided into a plurality of electrodes and configured to emit light by injecting a current into the active layer via the upper electrode layer and the lower electrode layer, and a control unit (150) configured to control a current injecting amount to the upper electrode layer and the lower electrode layer. The control unit controls a half-value width of the emission spectrum of the light-emitting element by varying a difference between an injection current density to a first electrode (111) and an injection current density to a second electrode (112) among the plurality of electrodes.

## Description

### BACKGROUND OF THE INVENTION

### Field of the Invention

This disclosure relates to a light source and an optical coherence tomography apparatus using the light source system.

### Description of the Related Art

A super luminescent diode (SLD) is a light-emitting element capable of obtaining a relatively high light output of 1mW or higher in the same manner as a semiconductor laser while at the same time providing a broadband spectrum distribution such as a light-emitting diode. The super luminescent diode may be abbreviated as SLD below.

The SLD attracts attention in a medical field or a measurement field because of its above-noted features. In the medical field, for example, is used as a light source of an optical coherence tomography (OCT) apparatus configured to obtain a tomographic image of a living tissue. The light source of the OCT apparatus having a broad light-emitting wavelength band is preferably used for increasing a depth resolution.

In Japanese Patent Application Laid-Open No. 2007-184557, a configuration in which at least one of an upper surface and a lower surface of the SLD is divided in a waveguide direction to make a spectrum distribution of light variable is disclosed.

### SUMMARY OF THE INVENTION

In OCT, there are various objects of measurement and if detailed tomographic image of the object of measurement is wanted, increase in the depth resolution is desirable. However, there is also a case where low the depth resolution may be acceptable, when the tomographic image is desired to be obtained quickly.

Japanese Patent Application Laid-Open No. 2007-184557 proposed that an emission spectrum may be configured to be a broadband by dividing light-emitting wavelength bands for each of electrodes of an SLD and then coupling again. However, a dip in the spectrum tends to be formed when the light-emitting wavelength bands are divided. In the case where there is the dip in the emission spectrum, that is, if a light-emission intensity at a specific wavelength is low, a virtual image (artifact) may be generated on the tomographic image. In other words, it is hard to simultaneously achieve both of broadening the wavelength band and preventing formation of the dip in the emission spectrum. Therefore, there are the case where the depth resolution may be low (the light-emitting wavelength band is narrow), but minimizing the virtual image is desired, and the case where the virtual image is acceptable to some extent, but a high depth resolution is desired (a broad light-emitting wavelength band is desired). In Japanese Patent Application Laid-Open No. 2007-184557, the fact that the light spectrum distribution of the SLD is variable is disclosed, but the technological shortcomings as described above are not addressed, and a specific measure for making the emission spectrum to a desired shape is not disclosed.

### SUMMARY OF THE INVENTION

Accordingly, the present inventors disclose embodiments of a light-emitting element capable of varying an emission spectrum to a desired shape.

According to an embodiment, a light source system as specified in claims 1 to 11.

The present invention in its second aspect provides an optical coherence tomography apparatus as specified in claim 12.

Further features of the present invention will become apparent from the following description of exemplary embodiments with reference to the attached drawings.

### BRIEF DESCRIPTION OF THE DRAWINGS

Fig. 1A is a perspective view, Fig. 1B is a top plane view and Fig. 1C is a cross-sectional view illustrating a light-emitting element according to a first embodiment of this disclosure.
Fig. 2 is a drawing illustrating a configuration of a light source system according to the first embodiment of this disclosure.
Figs. 3A and 3B are explanatory drawings illustrating effects obtained by using the light source system of the first embodiment of this disclosure.
Fig. 4 is an explanatory drawing illustrating a configuration of an OCT apparatus using the light source system according to a second embodiment of this disclosure.
Figs. 5A and 5B are drawings illustrating an emission spectrum obtained by using a light source system of Example 1 of this disclosure.
Figs. 6A and 6B are drawings illustrating a PSF of the emission spectrum obtained in Example 1 of this disclosure.
Fig. 7 is a drawing illustrating a top view configuration of a light-emitting element of Example 2 of this disclosure.
Figs. 8A and 8B are drawings illustrating an emission spectrum obtained by using a light source system of Example 2 of this disclosure.
Figs. 9A and 9B are drawings illustrating a relationship between a light output intensity obtained by using the light source system of Example 2 of this disclosure and amount of current injection to a first electrode.
Fig. 10 is a drawing illustrating the PSF of the emission spectrum obtained in Example 2 of this disclosure.
Fig. 11 is a drawing illustrating a relationship between a length of a non-injection electrode in Example 2 of this disclosure and a peak wavelength.
Figs. 12A and 12B are drawings illustrating an emission spectrum of a light-emitting element of Example 3 of this disclosure.

### DESCRIPTION OF THE EMBODIMENTS

### First Embodiment

### Light-Emitting Element

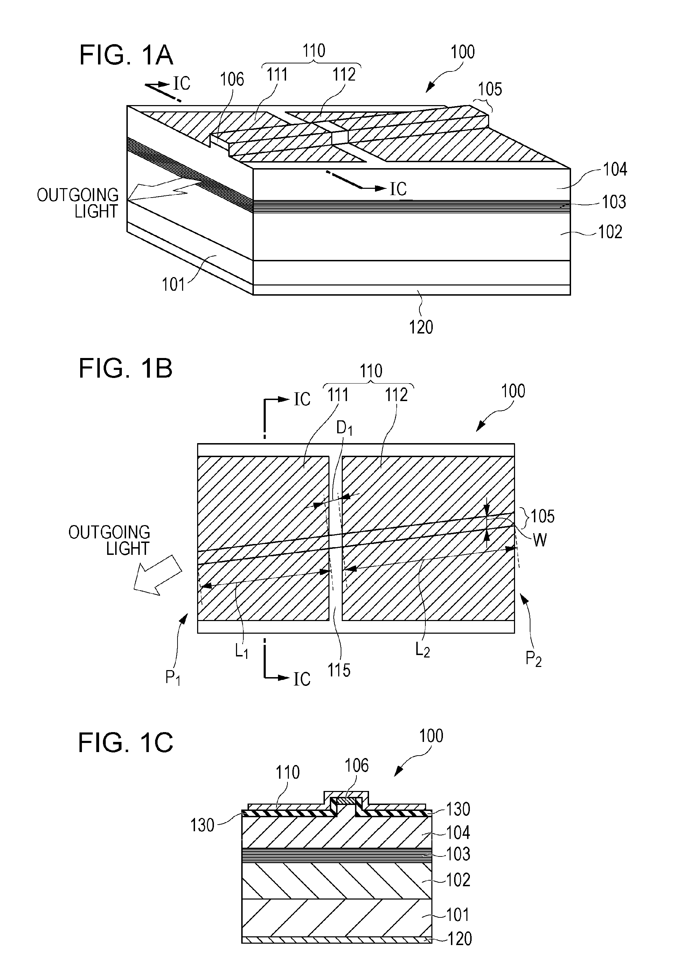

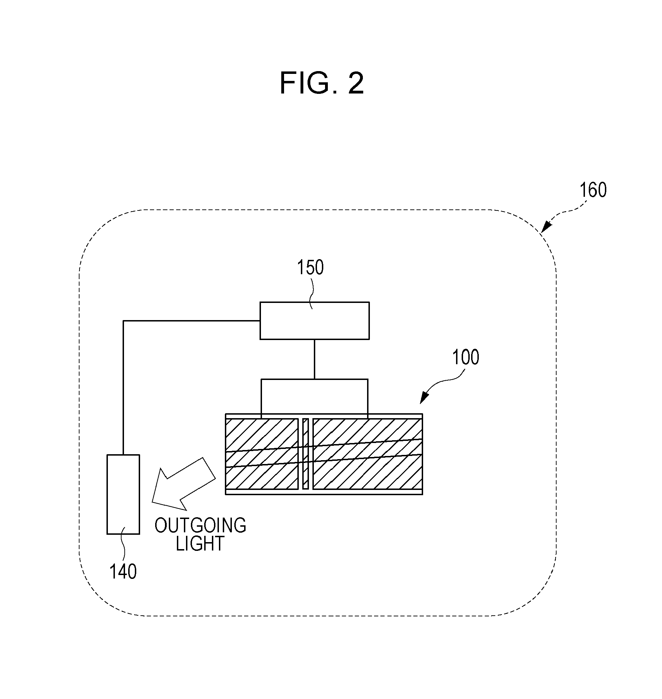

A light-emitting element and a light source system of a first embodiment of this disclosure will be described with reference to Figs. 1A to 1C and Fig. 2. Fig. 1A and Fig. 1B are a perspective view and a top view of a light-emitting element of the first embodiment, and Fig. 1C is a cross-sectional view taken along a line IC-IC in Figs. 1A and 1B.

A light-emitting element 100 of the first embodiment includes a lower clad layer (n-type clad layer) 102, an active layer 103, and an upper clad layer (p-type clad layer) 104 formed in sequence on a substrate (n-type substrate) 101. The upper clad layer 104 and an upper electrode layer 110 constitute part of a ridge-type waveguide structure 105. The upper electrode layer (p-type electrode) 110 is formed on an upper portion of the ridge-type waveguide structure 105 via a contact layer 106. As illustrated only in Fig. 1C, an insulation layer 130 is provided between the upper electrode layer 110 and the upper clad layer 104 to achieve a configuration in which an electric current is injected into the active layer 103 from the upper electrode layer 110 via the contact layer 106.

The upper electrode layer 110 is provided with a first electrode 111 and a second electrode 112 different from the first electrode 111 by being divided in a longitudinal direction (in an in-plane direction of the active layer 103) of the ridge-type waveguide structure 105. In other words, the upper electrode layer 110 includes the first electrode 111 and the second electrode 112 divided in a direction in which light is guided by the waveguide structure. The direction of the "OUTGOING LIGHT" is graphically shown by the wide arrow having substantially a same direction as that of the ridge-type waveguide structure 105.

A lower electrode layer 120 is formed on a surface out of the surfaces of the substrate 101, where the lower clad layer 102, is not provided. As illustrated in Fig. 1B, an electrode dividing area 115, in which no current is injected, is provided between the first electrode 111 and the second electrode 112. In the electrode dividing area 115, the contact layer 106 is removed for restraining a current leakage from the first electrode and the second electrode to electrodes adjacent thereto, and an electric resistance value is relatively high.

In other words, the light-emitting element of the first embodiment includes an laminate (laminate structure) having the upper electrode layer, the active layer, and the lower electrode layer in this order, and the laminate includes a waveguide structure configured to guide light in a direction perpendicular to a direction of lamination of the respective layers which constitute part of the laminate.

The light-emitting element 100 of the first embodiment is configured to apply a voltage via the first electrode 111, the second electrode 112, and the lower electrode layer 120 to cause the active layer 103 to emit light, guide the light in an in-plane direction in the active layer (a direction in which the light is guided by the waveguide structure), and emit the light in a direction indicated by a hollow arrow in Figs. 1A to 1C. A surface out of end surfaces of the light-emitting element 100, from which the light goes out, is referred to as an outgoing end surface here. As illustrated in Fig. 1A, the first electrode 111 is provided on the outgoing end surface side, and the second electrode 112 is provided on the opposite end surface side from the outgoing end surface. In Fig. 1B, the light-emitting element of the first embodiment is illustrated with P₁ as an outgoing end surface and P₂ as an opposite end surface from the outgoing end surface. The light emitted from the outgoing end surface P₁ is coupled to an optical member such as a lens and an optical fiber. A reflection preventing member or a material configured to absorb light are provided on the opposite end surface P2, which is opposite to the outgoing end surface, as needed so that the light is not returned by being reflected.

Examples of the light-emitting element of the first embodiment include a super luminescent diode (SLD). The SLD is capable of outputting light having a wavelength band as broad as several tens nm to 100 nm at an output power as high as several mW to several tens of mW.

Referring now to Fig. 2, the light source system of the first embodiment will be descried. Fig. 2 is a block diagram illustrating the light source system of the first embodiment, and in Fig. 2, the light-emitting element 100 is illustrated as a top view.

A light source system 160 of the first embodiment includes an outgoing light detecting unit 140 configured to detect an intensity of light outgoing therefrom, and a control unit 150 configured to control a injection current density to the respective electrodes, such as the first electrode 111 and the second electrode 112. The control unit 150 is configured to be capable of controlling the injection current density to the respective electrodes in accordance with the light intensity detected by the outgoing light detecting unit 140. The control unit 150 may be configured to monitor the light intensity detected by the outgoing light detecting unit 140 and to be capable of varying the current injecting amount to the respective electrodes.

The light source system of the first embodiment is configured to be capable of controlling so that a half-value width of the emission spectrum of the light-emitting element is varied by varying a difference between an injection current density to the first electrode from among the plurality of electrodes and an injection current density to the second electrode.

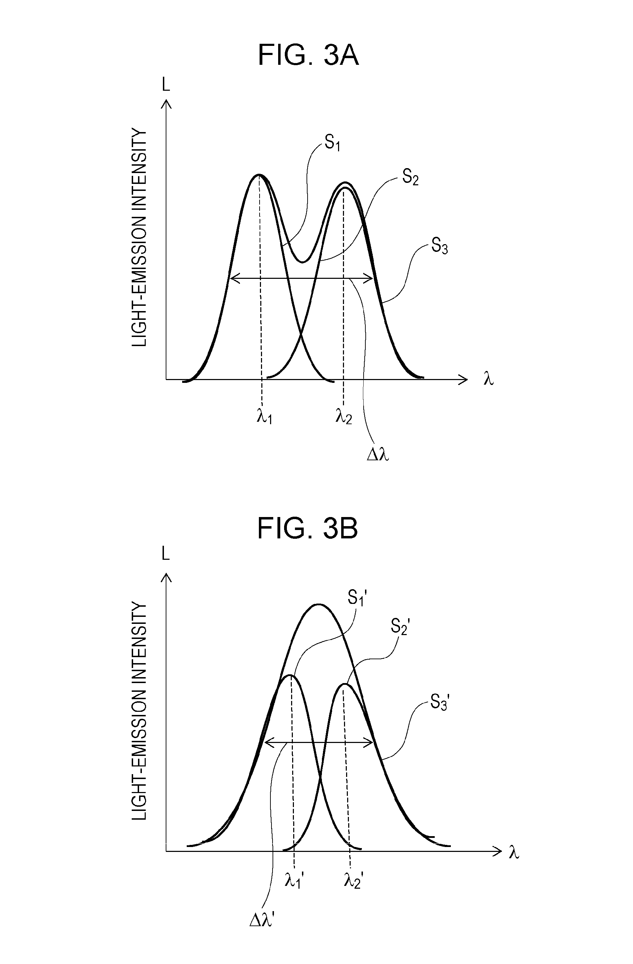

Subsequently, the width or the intensity of the wavelength band of the outgoing light, that is, a shape of the emission spectrum may be varied by adjusting the injection current densities to the first electrode 111 and the second electrode 112 as needed. A method of varying the shape of the emission spectrum will be described in detail with reference to Figs. 3A and 3B. Figs. 3A and 3B are drawings illustrating variations of the emission spectrum when the injection current density is varied. Figs. 3A and 3B are image drawings of the emission spectrum, and do not indicate actually measured emission spectrum.

Firstly, a current is injected to the first electrode 111 at an injection current density of J₁, and to the second electrode 112 at an injection current density of J₂. A state of being driven at the injection current density as described above is determined to be a first mode. With the value of J₂ smaller than that of J₁, a central wavelength λ₁ of the emission spectrum generated by a current injection from the first electrode may be made to be smaller than a central wavelength λ₂ of the emission spectrum generated by a current injection from the second electrode 112. This is because of a character that a light-emission intensity of a short wavelength band is increased with an increase of the injection current density. The reason is that among light-emitting levels of the active layer, a high injection current density is required for emitting light of a high order level (short wavelength band).

In Fig. 3A, S₁ denotes an emission spectrum obtained only by a current injection to the first electrode 111, S₂ denotes an emission spectrum obtained only by a current injection to the second electrode 112, and S₃ denotes an emission spectrum obtained when a current is injected to both of the first and second electrodes. In the first mode, since a difference between λ₁ and λ₂ is large, a half-value width Δλ of the emission spectrum S₃ is large. Therefore, if an OCT is driven in the first mode by using the light-emitting element of the first embodiment, a tomographic image having a high depth resolution is obtained. In the case where the current is injected to both of the first and second electrodes, light emitted from the active layer corresponding to the second electrode generates an additional stimulated amplification when passing through the active layer corresponding to the first electrode, so that the value of S₃ does not become simply a sum of S₁ and S₂.

Subsequently, a current is injected to the first electrode 111 at an injection current density of J₁', and to the second electrode 112 at an injection current density of J₂'. When the value of J₁' is smaller than J₁, the central wavelength becomes λ₁'_{,} which is longer than λ₁. When the value of J₂' is larger than J₂, the central wavelength becomes λ₁', which is shorter than λ₁. A state of being driven at the injection current density as described above is determined to be a second mode. In Fig. 3B, S₁' denotes an emission spectrum obtained only by a current injection to the first electrode 111, S₂' denotes an emission spectrum obtained only by a current injection to the second electrode 112, and S₃' denotes an emission spectrum obtained when a current is injected to both of the first and second electrodes. In the second mode, a half-value width Δλ', which is a difference between λ₁' and λ₂'. Therefore, by using the light-emitting element of the second embodiment in OCT, the depth resolution becomes lower than that in the first mode. In other words, by switching the mode of the difference between the injection current density to the first electrode and the injection current density to the second electrode from ΔJ (= J₁ - J₂) to ΔJ' (= J₁' - J₂'), which is a smaller than the value of ΔJ, a half-value width of the emission spectrum may be reduced. In contrast, by switching the mode from ΔJ' to ΔJ, the half-value width of the emission spectrum may be increased. However, as illustrated in Figs. 3A and 3B, the emission spectrum S₁' is smaller in dip of the emission spectrum than S₁. It is because the half-value width of the emission spectrum is increased by increasing the difference between the central wavelengths λ₁ and λ₂ in the first mode. Accordingly, a dip tends to be formed in the wavelength band between λ₁ and λ₂ (Fig. 3A). In contrast, since the difference between λ₁' and λ₂' is small, the dip is not formed or only a small dip is formed in the emission spectrum obtained in the second mode. In the case where only a small dip is formed, a virtual image is not generated in the tomographic image obtained by the OCT.

In addition, in the case of detecting an interference light with a line sensor such as a spectral domain OCT (SD-OCT), if the half-value width of the emission spectrum of the light-emitting element is narrow, the wavelength band of the interference light to be detected becomes also narrow, and time for detecting the interference light (read-in time) is short. Therefore, when the OCT is driven in the second mode, the depth resolution of the tomographic image is lower than the case where the OCT is driven in the first mode. However, the tomographic image is obtained at a high speed with a shorter detection time, and a virtual image can hardly be generated in the obtained tomographic image. In contrast, when the OCT is driven in the first mode, the depth resolution of the tomographic image is higher than the case where the OCT is driven in the second mode. However, longer detection time is required and generation of a virtual image in the obtained tomographic image is substantially suppressed.

A peak intensity of the emission spectrum is larger when driven in the second mode than in the first mode. This is because the difference between λ₁' and λ₂' is reduced and peaks of S₁' and S₂' get closer as illustrated in Fig. 3B, so that the value of the coupled wave is increased.

The SD-OCT employing a light source having a high peak intensity of the emission spectrum is capable of obtaining the tomographic image at a high speed. The reason will be described below. In the SD-OCT, time required for converting light to a carrier and accumulating the carrier with the line sensor occupies major part of time required for detection of the interference light. In order to increase the value of S/N and prevent a signal from saturating, the carriers need to be accumulated for a certain suitable time range. Therefore, if the intensity of the emission spectrum is high, accumulated time may be reduced correspondingly. Consequently, the image may be acquired at a high speed.

When the mode is changed from the first mode to the second mode, or from the second mode to the first mode, a change in light output intensity (a value of integral of the intensity of the emission spectrum in the used wavelength band) is preferably small. The reason will be described below.

In many cases, the intensity of light with which the object of measurement may be irradiated is limited. In particular, the OCT is used for obtaining the tomographic image of an eyeground, and the intensity of light incident on an eye has a safety limitation. In contrast, from the viewpoint of a measurement accuracy, the ratio of S/N needs to be increased as much as possible. Therefore, the suitable light output intensity from the viewpoint of the measurement accuracy is preferably a light output intensity closest to the safety limitation. Actually, however, driving at a light output with a room added thereto so as to prevent an excess of a limit value even though the light output intensity varies to some extent is required for securing the safety. Therefore, the light source to be used in the OCT is optimally driven at a light output as high as possible with a room for safety added thereto for obtaining a tomographic image at a safe and high S/N. From this viewpoint, the variations in light output intensity is preferably kept at a constant value to some extent, and the variation range is preferably 20% or lower, more preferably, 10% or lower. The variation range is an increase and decrease rate with respect to the light output intensity (mW) when being driven in the first mode in the example described above.

In contrast, in the light-emitting element, specifically, the SLD having a single electrode, if the driving current is varied, the spectrum also varies simultaneously together with the light output. Therefore, simple correction of the light output is not sufficient. This phenomenon will be described further in detail with reference to IEEE Journal of Quantum Electronics Vol. 44, p. 1256 (2008). The SLD accumulates carriers in a quantum well layer in an active layer by a current injection, and emits light by natural emission or induced emission in the quantum well layer. Therefore, if the current magnitude to be injected is varied, a carrier density to be accumulated varies. As described in IEEE Journal of Quantum Electronics Vol. 44, p. 1256 (2008), if the carrier density is varied, a wavelength dependency of the gain (hereinafter, referred to as a gain spectrum) varies (for example, see Fig. 1 in IEEE Journal of Quantum Electronics Vol. 44, p. 1256 (2008)). As more specific variations in gain spectrum, the gain from a ground level becomes dominant when the carrier density is low. When the current magnitude to be injected is increased, the carrier density is increased, and the gain from the light-emitting level having a shorter wavelength is increased relatively with respect to the gain from the ground level. At a certain time point, the gain exceeds that from the ground level. Therefore, light-emission with the broadest band may be realized at a certain carrier density at which the gains from the ground level and a high order level become the same value. In IEEE Journal of Quantum Electronics Vol. 44, p. 1256 (2008), this specific carrier density is referred to as a TCD. In other words, the carrier density which corresponds to the TCD is a certain value, and the value of the injection current corresponding thereto becomes one certain value. Therefore, when the current magnitude to be injected is apart from the conditions of the TCD at which the emission spectrum becomes a broadband, a balance of the gains between the ground level and the high order level is lost, and a gain state biased to one side results (see Fig. 1 in IEEE Journal of Quantum Electronics Vol. 44, p. 1256 (2008)). When the current magnitude to be injected is varied as a result, the spectrum shape from the SLD also varies simultaneously, and hence it is difficult to increase and decrease only the light output independently. The light-emitting element of the first embodiment is reduced in light-emission intensity if the state is changed from a state in which the current is injected to the first electrode 111 at the injection current density J₁ to a state in which the current is injected thereto at the injection current density J₁', which is smaller than J₁. In contrast, the light-emission intensity is increased if the state is changed from a state in which the current is injected to the second electrode 112 at the injection current density J₂ to a state in which the current is injected thereto at the injection current density J₂', which is larger than J₂. Therefore, the light-emitting element of the first embodiment is small in variation width of the output light intensity even when the mode is switched between the first mode and the second mode.

Having the plurality of electrodes and, in addition, being provided with the active layer having an asymmetric multiple quantum well structure as the light-emitting element of the first embodiment is preferable. With the provision of the plurality of electrodes, the injection current density to be injected to each of the electrodes may be varied as needed to adjust the shape of the emission spectrum arbitrarily. In addition, if the asymmetric multiple quantum well structure having a well structure shallower than the quantum well structure added to a single quantum well structure is employed as the active layer, emission of light at the ground level of the shallow well may cause an stimulated amplification of the emitted light at the high order level of a deep well. In other words, an electrode provided on the outgoing end surface side (a front electrode) increases the injection current density so as to cause emission of light at a high energy (a short wavelength band) at the high order level of the deep well structure out of the asymmetric multiple quantum well structure. In contrast, an electrode provided on the side opposite to an outgoing end surface (a rear electrode) reduces the injection current density, and causes emission of light at the ground level (high energy) of the shallow well structure. If the high order level of the deep well and the ground level of the shallow well substantially match at the level of the high energy, emission of light occurring due to the current injection to the rear electrode causes the stimulated amplification of emitted light at the high order level of the deep well, so that the light can be emitted easily. The emission of light at the ground level (high energy) of the shallow well structure occurs at a low injection current density. However, emission of light at the high order level (high energy) in the active layer having the deep well structure independently needs a high injection current density. Therefore, by using the asymmetric multiple quantum well structure, emission of light at the high energy (short wavelength band) may be realized at the low injection current density.

As described above, by using the light source system of the first embodiment, the shape of the emission spectrum may be changed into a desired shape. Respective components which constitute part of the light source system of the first embodiment will be described in detail below. Upper Electrode Layer

In the light-emitting element of the first embodiment, although the upper electrode layer is not specifically limited. However, an electrode layer having a second p-type electrode layer containing Au formed on a first p-type electrode layer having Ti may be used.

In the above-described description, a configuration in which the upper electrode layer constitutes an electrode set divided into two parts has been described. However, the upper electrode layer may be divided into four parts.

### Lower Electrode Layer

In the light-emitting element of the first embodiment, the lower electrode layer is not specifically limited. However, an electrode layer having an n-type electrode layer containing AuGe/Ni/Au may be used.

In the above-described description, a configuration in which the upper electrode layer is divided has been described. However, a light-emitting element in which the lower electrode layer is divided into the plurality of electrodes is also applicable. A light-emitting element in which the electrodes in which both of the upper electrode layer and the lower electrode layer are divided light-emitting element.

### Active Layer

The quantum well structure suitable for the active layer of the light-emitting element of the first embodiment is different depending on a wavelength of light to be emitted. An emission wavelength of the quantum well structure is determined depending on the material of a well layer and a barrier layer and on the thickness of the well layer. Hereinafter, an example of a quantum well suitable for the emission wavelength of the active layer will be described with a focus on the emission wavelength of the ground level of the quantum well.

For example, in order to achieve emission of light from the ground level having a wavelength in a range from 800 nm to 850 nm, AlₓGa₍₁₋ₓ)As in which an Al composition x is included in a range from 0 to 0.15 is preferable as the well layer. As the barrier layer, AlGaAs having an Al composition higher than that of the well layer is preferable. The thickness of the quantum well layer at this time is preferably included in a range from 5 nm to 10 nm. However, since the emission wavelength is determined by the thickness of the well layer and the material which constitutes the well layer, the emission wavelength within a range from 800 nm to 850 nm is achieved by reducing the thickness to be shorter than 5 nm and using a material having a wavelength with a small band gap correspondingly.

The active layer is not limited to the single quantum well structure, but may be the one having a plurality of different quantum well structures. In other words, a multiple quantum well structure having a plurality of quantum wells having different depths may be used as the active layer. The material is not limited to those described above, and a light-emitting material such as GaAs, GaInP, AlGaInN, AlGaInAsP, and AlGaAsSb may also be used.

In order to achieve emission of light in the ground level having a wavelength in a range from 850 nm to 900 nm, InₓGa₍₁₋ₓ₎As in which an In composition x is included in a range from 0 to 0.1 may be used. As the material of the barrier layer, GaAs or AlGaAs may be preferably used. The thickness of the well layer is preferably included in a range from 5 nm to 10 nm. However, since the emission wavelength is determined by the thickness of the well layer and the material which constitutes the well layer, the emission wavelength within a range from 850 nm to 900 nm is achieved by reducing the thickness to be shorter than 5 nm and using a material having a wavelength with a short band gap correspondingly. The active layer of the first embodiment preferably has the asymmetric multiple quantum well structure.

The material is not limited to those described above and any materials may be used as long as those materials emit light in the same wavelength band (band from 800 nm to 900 nm). For example, GaInAsP may be used for the well layer to realize the quantum well structure on the basis of the thought described above.

In the same manner, in other wavelength bands, a preferable active layer is achieved by using the well layer configured to emit light in the respective wavelength bands and the barrier layer formed of a material having a band gap wider than that of the well layer and adjusting the width of the well layer. For example, in a 980 nm band, InGaAs having an In composition near 0.2 is preferably used for the well layer. In a 1550 nm band, InGaAs having an In composition near 0.68 which is lattice-matched to InP substrate may be preferably used.

The structure of the active layer is not limited to the quantum well, and may have a quantum confinement structure such as quantum wires or quantum dots. Ridge-Type Waveguide Structure

The light-emitting element of the first embodiment formed with the ridge-type waveguide structure 105 is capable of confining light within the light-emitting element, guiding the light within the active layer, and causing the light to go out from the outgoing end surface. The ridge-type waveguide structure may be formed by a general semiconductor lithography method and a semiconductor etching method. The width (w in Fig. 1B) of the ridge-type waveguide structure is not specifically limited as long as the light may be confined, but is, for example, preferably 10 µm or below, preferably 5 µm or below, and more preferably 3 µm or below. The width of the ridge-type waveguide structure, that is, the ridge width w is preferably small so as not to cause the emission of light from the light-emitting element to be a multi-mode. Structure of Light Outgoing End Surface

In the light-emitting element of the first embodiment, the ridge-type waveguide structure 105 is inclined in the in-plane direction of the active layer with respect to a perpendicular line of the light outgoing end surface in order to resist lasing. By inclining the waveguide structure 105, light reflected from the end surface may be restrained from coupling with a waveguide, and hence lasing can hardly occur. For example, an inclination of approximately 7 degrees in the in-plane direction of the active layer with respect to the perpendicular line of the outgoing end surface is preferable. A dielectric film such as SiN may be provided as a reflection preventing film for restraining the reflection from the end surface. The reflection preventing film may be provided on one or both of the outgoing end surface and the end surface opposite thereto. Alternatively, an area in which no current is injected may be provided in the vicinity of the outgoing end surface for restraining deterioration on the outgoing end surface. Outgoing Light Detecting Unit

The outgoing light detecting unit 140 of the first embodiment is not specifically limited as long as the intensity of light emitted from the above-described light-emitting element may be detected. For example, a photo detector (hereinafter, may be abbreviated as PD) configured to detect the total amount the outgoing light or a line sensor configured to detect the emission spectrum, that is, the wavelength dependency of the light output intensity may be used. In the light source system of the first embodiment, the intensity of light in a certain wavelength band or the intensity of light in a plurality of wavelength bands may be detected. For example, a wavelength selection filter configured to transmit only light having the central wavelength λ₁ may be provided on a PD.

### Control Unit

The control unit of the first embodiment is not specifically limited as long as the injection current density to be injected into each of the electrodes may be controlled. Information on the intensity of light detected by the outgoing light detecting unit is sent to the control unit by using a feedback circuit, and the injection current density may be determined on the basis of the information received through the feedback circuit. Control unit which may be employed here includes a light source driver. The light source driver includes a circuit configured to adjust a current injecting amount and, as needed, a monitor unit configured to monitor a current amount to be injected. The Control unit may be packaged integrally with the light source, or may be provided separately and connected to each other.

One or a plurality of the control units of the first embodiment may be provided. In the case where a plurality of the control units are provided, a configuration in which the control unit is provided for each of the divided electrodes, or in which the one control unit is configured to be capable of controlling the current injecting amount to the plurality of electrodes is applicable.

For example, when two of the control units are provided, one of them may control the first electrode 111 on the outgoing end surface P₁ side and the adjusting electrode 112 and the other one may control a second electrode 113 on the end surface P₂ side.

### Manufacturing Method

A method of manufacturing the light-emitting element of the first embodiment is not specifically limited, but the light-emitting element may be manufactured by growing the respective semiconductor layers in sequence by using an MOCVD (Metal Organic Chemical Vapor Deposition) method.

### Second Embodiment

### OCT

### Optical Coherence Tomography

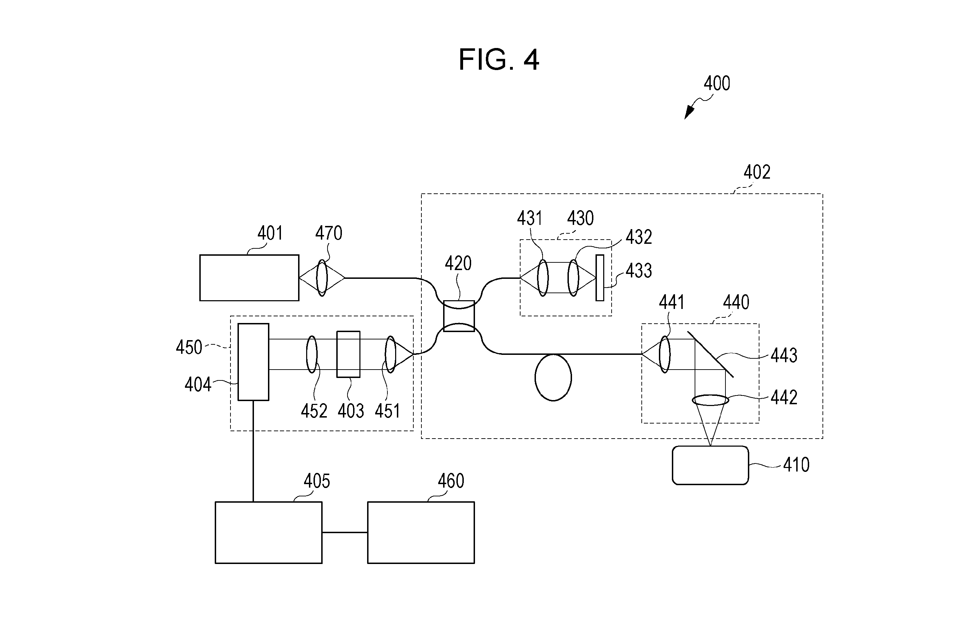

In a second embodiment, an optical coherence tomography (OCT) apparatus using the light source system of the first embodiment described above will be described with reference to Fig. 4.

As illustrated in Fig. 4, an OCT 400 of the second embodiment has a configuration including a light source system 401, an interference optical system 402, a spectroscope 403, an interference light detecting unit 404, and an information obtaining unit 405. Here, the light source system 401 is the light source system according to the first embodiment described above.

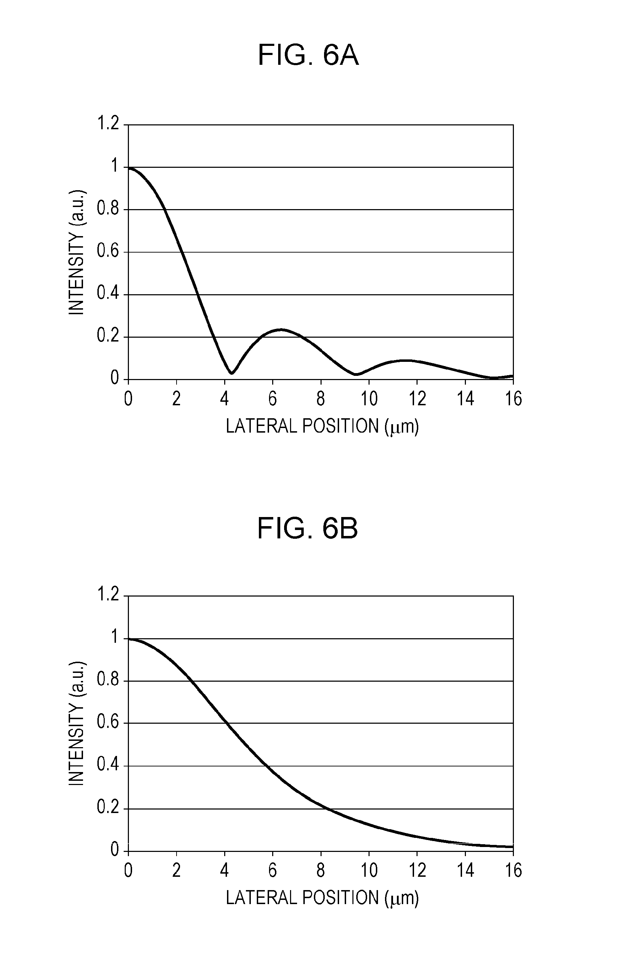

The interference optical system 402 branches light from the light source system 401 into a reference light branch and an illumination light branch. The illumination light branch carries irradiating light to be irradiated on an object 410. The interference optical system 402 causes interference between the reference light to with reflected light of the light irradiated on the object 410 to generate interference light. The interference light includes information on the object 410, which is an object to be measured. The interference light is branched by the spectroscope 403 and subsequently received (detected) by a light detecting unit 404 in such a manner that different positions of the interference light detecting unit 404 are irradiated with light beams having different wavelengths. The information obtaining unit 405 obtains information on the object 410 based on the intensity of the interference light. More specifically, the information obtaining unit 405 forms a tomographic image from the information on the intensity of light received by the interference light detecting unit 404. Subsequently, a detailed configuration of the OCT of the second embodiment will be described with reference to Figs. 6A and 6B. Information obtaining unit 405 includes a detection unit configured to detect a detection signal from the light detecting unit 404 and a processing unit such as a CPU configured to process the detection signal obtained by the detection unit and calculate information such as the tomographic image. The information obtaining unit 405 may include a storage unit such as a memory for memorizing data calculated during a process to be performed after an obtainment of the detection signal until creation of information such as the tomographic image and data used in calculation as needed. The detecting unit, the processing unit, and the storage unit are not illustrated in the drawings.

In the OCT apparatus illustrated in Fig. 4, light outgoing from the light source system 401 is branched into the irradiating light and the reference light by a branching unit 420 of the interference optical system 402. The irradiating light passes through an irradiation optical system 440, is reflected by the object 410, which is an object to be measured, and hence becomes reflected light, and together with the reference light reflected by a reference optical system 430 generates interference light at the interfering unit (branching unit) 420. The OCT of the second embodiment includes a light-detection optical system 450 configured to detect the interference light generated in the interfering unit 420, the information obtaining unit 405 configured to acquire information on the tomographic image on the basis of the light detected by the light-detection optical system 450, and a display unit 460 configured to display the tomographic image.

The light source system 401 branches light into the reference light and the irradiating light by the branching unit (interfering unit) 420 via an optical fiber, and part of the branched light enters the reference optical system 430. Here, the branching unit 420 and the interfering unit 420 use the same fiber coupler. The reference optical system 430 includes collimator lenses 431 and 432 and a reflection mirror 433, and the reference light reflected by the reflection mirror 433 enters the optical fiber again. The irradiating light, which is the other part of the light branched by the branching unit 420 from the optical fiber, enters the irradiation optical system 440. The irradiation optical system 440 includes collimator lenses 441 and 442, and the reflection mirror 443 configured to bend the optical path by an angle of, for example, 90°. The irradiation optical system 440 has a role to cause incident light to enter the object 410, which is an object to be measured, and couple the reflected light again to the optical fiber.

The light returned from the reference optical system 430 and the irradiation optical system 440 passes through the interfering unit 420, and enters the light-detection optical system 450. The light-detection optical system 450 includes collimator lenses 451 and 452 and a diffractive grating 403 as the spectroscope. The light-detection optical system 450 also includes the line sensor 404 configured to obtain spectrum information on the light branched by the diffractive grating 403.

In the OCT of the second embodiment, an example of a configuration in which the reference optical system 430 includes the reflection mirror 433, and the light reflected therefrom returns back to the interfering unit 420 is shown. However, a configuration in which the reflection mirror 433 is not provided and the reflected light reaches the interfering unit 420 via an optical path having an adequate optical path length is also applicable.

The OCT of the second embodiment is effective when obtaining a tomographic image of biological bodies such as animals or humans in departments of ophthalmology, dentistry, dermatology and the like. Information on the tomographic image of the biological bodies includes not only the tomographic image of the biological bodies, but also numerical data required for obtaining the tomographic image. It is specifically preferable to be used for measuring an eyeground of human being as an object to be measured, and obtaining information on the tomographic image of the eyeground. The OCT may be referred to also as an OCT apparatus.

### Other applications

The light-emitting element (light source system) of the second embodiment of this disclosure may be used as an optical communication light source or as an optical measurement light source in addition to the above-described

### OCT.

### Examples

Examples of this disclosure will be described below. An active layer structure and a layer structure described in the examples given below are examples only, and are not intended to limit this disclosure. A method of manufacturing the light-emitting element will be described in detail in the examples. However, sizes, respective manufacturing processes, apparatuses, and various parameters of the respective components of the light-emitting element are not limited to these examples. A semiconductor material, an electrode material, and a dielectric material are not limited to those disclosed in the examples. In addition, the conducting types of the respective semiconductor layers are not limited to those exemplified in these examples, and an example of p-type may be replaced by n-type, and an example of n-type may be replaced by p-type.

### Example 1

The light-emitting element of Example 1 has a configuration illustrated in Fig. 1. In the light-emitting element of Example 1, a GaAs substrate was used as the substrate 101, an N-type Al_{0.5}GaAs clad layer was used as the lower clad layer 102, and a p-type Al_{0.5}GaAs clad layer was used as the upper clad layer 104 of the active layer 103. A p-type GaAs contact layer was used as the contact layer 106. The active layer 103 included two quantum well structures including two quantum well layer of In_{0.07}GaAs having a thickness of 8 nm and barrier layers of Al_{0.2}GaAs, and a quantum well structure including a quantum well layer of GaAs having a thickness of 6 nm and barrier layers of Al_{0.2}GaAs. An n-type electrode was used as the lower electrode layer 120 and a p-type electrode was used as the upper electrode layer 110. In Example 1, the upper electrode layer 110 was divided into two parts. A length of the first electrode 111 in the waveguide direction was 0.29 mm, a length of the second electrode 112 in the waveguide direction was 0.30 mm, and the ridge width w was 3µm. The light source system of Example 1 includes the control unit 150 configured to control the injection current density to the first electrode 111 and the second electrode 112 in addition to the light-emitting element having the configuration described above.

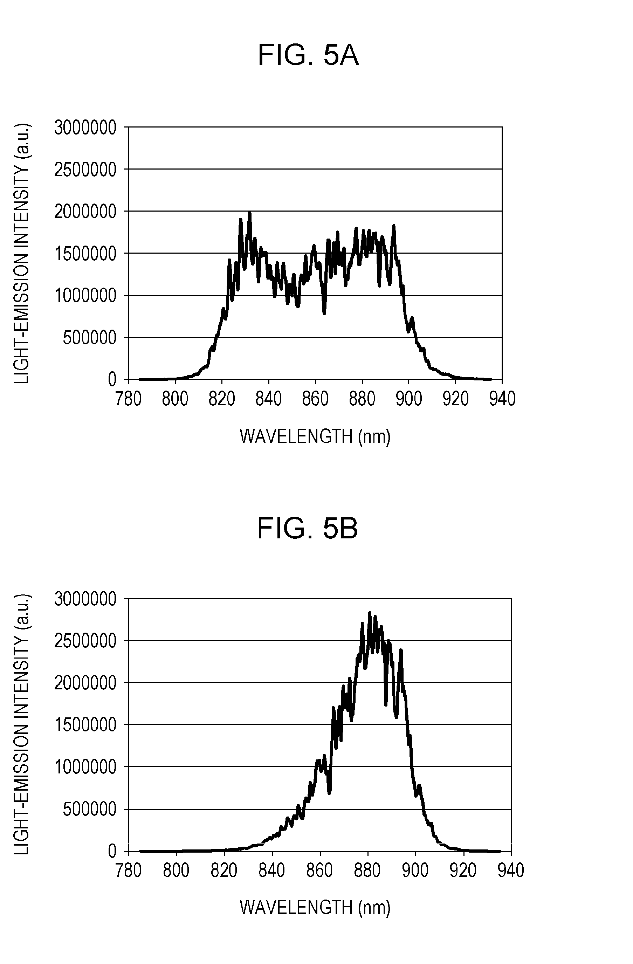

As a driving condition for obtaining a tomographic image having a high depth resolution in the case where the light source system of Example 1 was used in the OCT, a current of 150 mA was injected to the first electrode 111, and a current of 20 mA was injected to the second electrode 112 (hereinafter, this driving condition is referred to as a first mode). The emission spectrum obtained in the first mode is illustrated in Fig. 5A. The spectrum width (half-value width) was 78 nm, and the light output intensity was 13.2 mW.

In contrast, as a driving condition for obtaining a tomographic image at a high speed, a current of 75 mA was injected to the first electrode 111 and a current of 35 mA was injected to the second electrode 112 (hereinafter, this driving condition is referred to as a second mode). The emission spectrum obtained in the second mode is illustrated in Fig. 5B. The spectrum width (half-value width) was 33 nm, and the light output intensity was 12.4 mW.

The emission spectrum obtained by driving the light source system in the first mode in this manner had a half-value width wider than that in the second mode, but had a lower light-emission intensity in the vicinity of 850 nm. The emission spectrum obtained by driving in the first mode had a wide half-value width. Therefore, if it was used in the OCT, the wavelength band of the interference light was increased, and hence it required a long reading time for the line sensor, so that it took a long time for obtaining the tomographic image. In contrast, the emission spectrum obtained by driving in the second mode had a half-value width narrower than that in the first mode. However, there was no area having a low light-emission intensity, and a peak intensity was also high. The emission spectrum obtained by driving in the second mode had a narrow half-value width and a high peak intensity. Therefore, if it was used in the OCT, the wavelength band of the interference light was reduced, and hence it required only short reading time for the line sensor in comparison with the first mode, so that the tomographic image could be obtained in short time.

The variation range of the light output intensity when being changed from the first mode (13.2 mW) to the second mode (12.4 mW) was 6.1 %, and the variation range was small.

Subsequently, the fact that the emission spectrum illustrated in Fig. 5A has a higher resolution than the emission spectrum illustrated in Fig. 5B will be shown with calculation. In the SD-OCT, the numerical value of the resolution is indicated by Point Spread Function (PSF), and twice the half-value width thereof corresponds to a resolution of the tomographic image obtained by the SD-OCT.

The calculated values of the PSFs of the emission spectrum illustrated in Fig. 5A and the emission spectrum illustrated in Fig. 5B are illustrated in Figs. 6A and 6B respectively. The half-value width of the PSF illustrated in Figs. 6A and 6B are 2.6 µm in the first mode and 4.9 µm in the second mode. In other words, resolutions as the SD-OCT when assuming to be in the air are 5.2 µm in the first mode and 9.8 µm in the second mode. When assuming to be in a medium having a refractive index of 1.38, the resolutions are 3.8 µm in the first mode and 7.1 µm in the second mode.

In this manner, the resolutions obtained in the first mode is 1.9 times higher than the resolution obtained in the second mode.

### Example 2

The light-emitting element of Example 2 of this disclosure will be described. The light-emitting element of Example 2 is different from the light-emitting element of Example 1 in that the upper electrode layer of the light-emitting element is divided into six parts, and other portions are the same. Hereinafter, only items different from Example 1 will be described, and description of common items will be omitted.

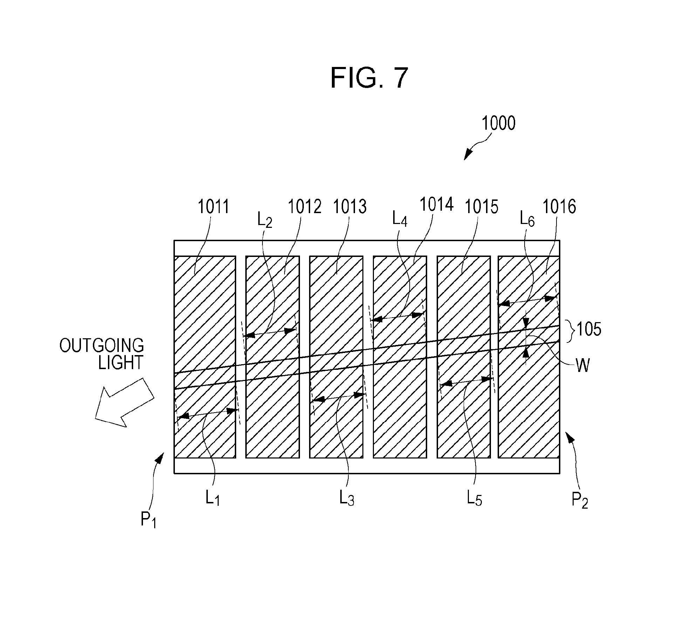

Fig. 7 is a top view of a light-emitting element 1000 of Example 2. As illustrated in Fig. 7, the upper electrode layer is divided into a first electrode 1011, a second electrode 1012, a third electrode 1013, a fourth electrode 1014, a fifth electrode 1015, and a sixth electrode 1016. The lengths of the respective electrodes in the waveguide direction were set to 0.3 mm in a length L₁ of the first electrode, 0.3 mm in a length L₂ of the second electrode, 0.5 mm in a length L₃ of the third electrode, 0.3 mm in a length L₄ of the fourth electrode, 0.7 mm in a length L₅ of the fifth electrode, and 0.3 mm in a length L₆ of the sixth electrode. The width w of the ridge waveguide structure 105 was set to 3 µm.

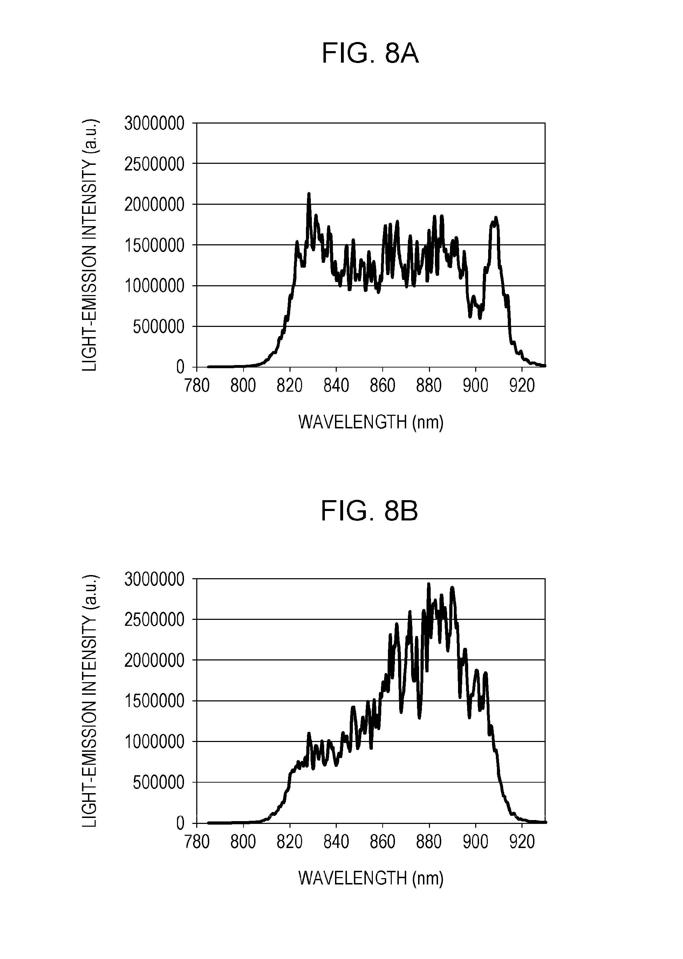

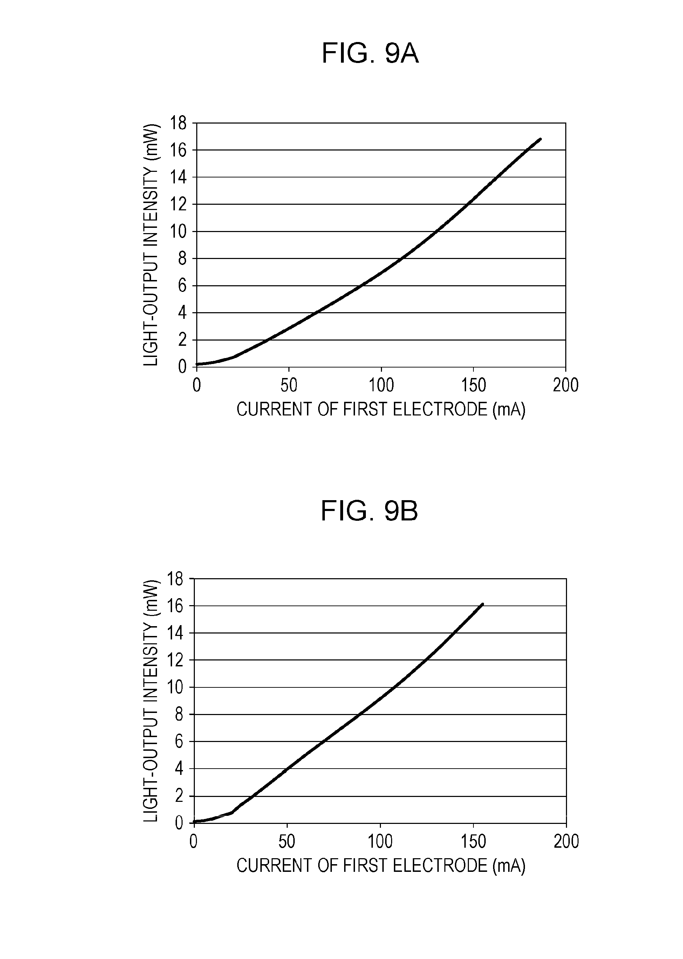

In Example 2, in the first mode, a current of 150 mA was injected to the first electrode 1011, a current of 15 mA was injected to the second electrode 1012, and a current of 180 mA was injected to the sixth electrode 1016. No current was injected to other electrodes. The emission spectrum obtained in this first mode is illustrated in Fig. 8A. A variation in light output intensity when a current to be injected into the first electrode 1011 was varied in a state in which a current of 15 mA was injected to the second electrode 1011 and a current of 180 mA was injected to the sixth electrode 1016 is illustrated in Fig. 9A. It is understood from Fig. 8A that the half-value width of the emission spectrum was approximately 90 nm. It is also understood from Fig. 9A that the light output intensity was 12.3 mW in the first mode (a current of 150 mA was injected into the first electrode).

In Example 2, in the second mode, a current of 130 mA was injected to the first electrode 1011, a current of 20 mA was injected to the second electrode 1012, and a current of 30 mA was injected to the fourth electrode 1014. No current was injected to other electrodes. The emission spectrum obtained in this second mode is illustrated in Fig. 8B. A variation in light output intensity when a current magnitude to be injected into the first electrode 1011 was varied in a state in which a current of 20 mA was injected to the second electrode 1012 and a current of 30 mA was injected to the third electrode 1013 is illustrated in Fig. 9B. It is understood from Fig. 8B that the half-value width of the emission spectrum was approximately 50 nm. It is also understood from Fig. 9B that the light output intensity was 12.6 mW in the second mode (an amount of current injection to the first electrode is 130 mA). From the result described above, the variation range of the light output intensity between the first mode and the second mode was 4%.

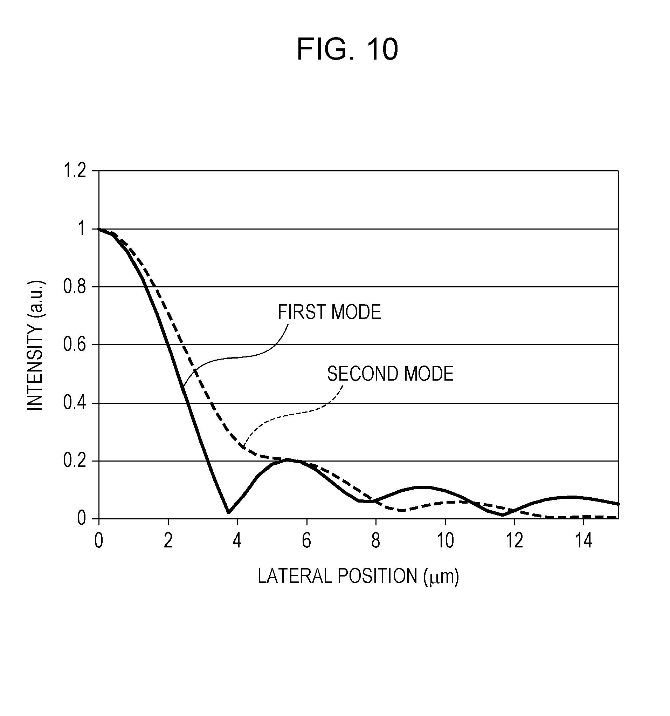

Subsequently, the result of calculation of the PSFs of the emission spectrum obtained in the first mode and the second mode respectively are illustrated in Fig. 10. It is understood that the depth resolution in the air was 4.6 µm in the first mode and 4.8 µm in the second mode from Fig. 10. The depth resolution in a medium having a refractive index of 1.38, the resolutions are 3.3 µm in the first mode and 3.5 µm in the second mode. Therefore, if the tomographic image having a high depth resolution is wanted, the tomographic image is obtained by driving in the first mode.

In addition, with the PSF, an index relating to an image quality in the SD-OCT is also obtained in addition to the depth resolution. It is an index relating to a side lobe. In Fig. 10, it is understood from Fig. 10 that the position of the intensity was the highest at 0 on a lateral axis, and was reduced as it proceeds toward the greater value along the lateral axis, and that the intensity was not decreased monotonously in both driving conditions, was turned to increase from an extremely low value, and had an extremely high value.

If it is applied to the image of the SD-OCT, this corresponds to a magnitude of a signal generated derivatively at a position away from the original signal (corresponding to the position 0 on the lateral axis in the PSF) by being affected by the original signal. The smaller side lobe is more preferable.

It is understood from Fig. 10 that when the magnitudes of the side lobes under the respective driving conditions were compared, the side lobe in an area outside of 8 µm was suppressed to a level of 50% or lower in the second mode in comparison with that under the third driving condition. Therefore, in the case where a tomographic image in which suppression of the influence of the side lobe has a higher priority than obtaining higher resolutions is wanted, the tomographic image is obtained by driving the light-emitting element in the second mode.

As described above, in Example 2, as regards the quality of the image to be obtained, whether the priority is put on the resolution or on a reduction of the side lobe may be changed only by varying the current magnitude to be injected to the electrode of the light-emitting element. Since the variation range of the light output intensity is restrained to 4%, the light output intensity may be maintained within a desirable range in both of the driving conditions.

In Example 2, the emission spectrum of the light-emitting element was controlled by using a method of controlling current densities to the first and second electrodes described in the embodiments. In addition, in Example 2, one or more electrode to which no current was injected (hereinafter, referred to as non-injection electrode) were interposed between the second electrode and the fourth or sixth electrode. With the provision of the non-injection electrode, a peak near a wavelength of 910 nm which was appeared in Fig. 8A occurred. It can be understood by comparing with the emission spectrum in Fig. 5A, which is the spectrum of Example 1 formed of the same semiconductor layer and does not use the non-injection electrode.

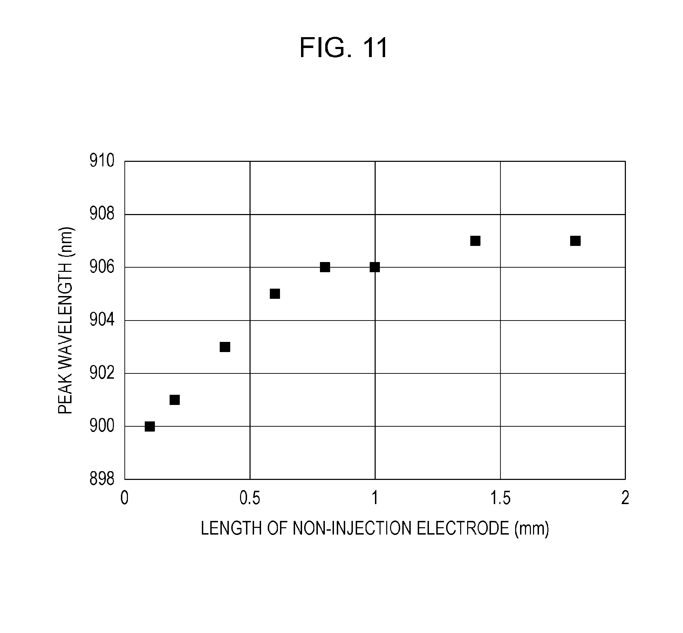

The total length of the non-injection electrode in the waveguide direction in the first mode is longer than that in the second mode. The total length is a value obtained by integrating the lengths of the non-injection electrodes, and the length of the electrode dividing area is not added. Fig. 11 illustrates an experimental example showing a relationship between the length of the non-injection electrode and the wavelength of a generating emission peak. As is understood from Fig. 11, if the length of the non-injection electrode increases, the emission peak moves to the long wavelength side. Therefore, in order to increase the half-value width of the light-emitting wavelength of the light-emitting element, the longer non-injection electrode is preferable. However, if the non-injection electrode is too long, a gap is formed between the peak and the light-emitting wavelengths generating from the first and second electrodes. In the case where this gap is not preferable, the length of the non-injection electrode needs to be limited to a certain length.

In the first mode, the emission peak is positioned on the long wavelength side and, as a result, the priority is put on an increase of the wavelength width of the emission spectrum from the light-emitting element. The reason is that the wider the wavelength width, the more the resolution of the tomographic image of the SD-OCT is improved.

In contrast, in the second mode, the priority is put on preventing the formation of the gap. The reason is that the closer the spectrum of the light-emitting element toward Gauss function, the less the side lobe occurs.

### Example 3

A configuration of the light-emitting element of Example 3 is the configuration illustrated in the first embodiment (Figs. 1A to 1C).

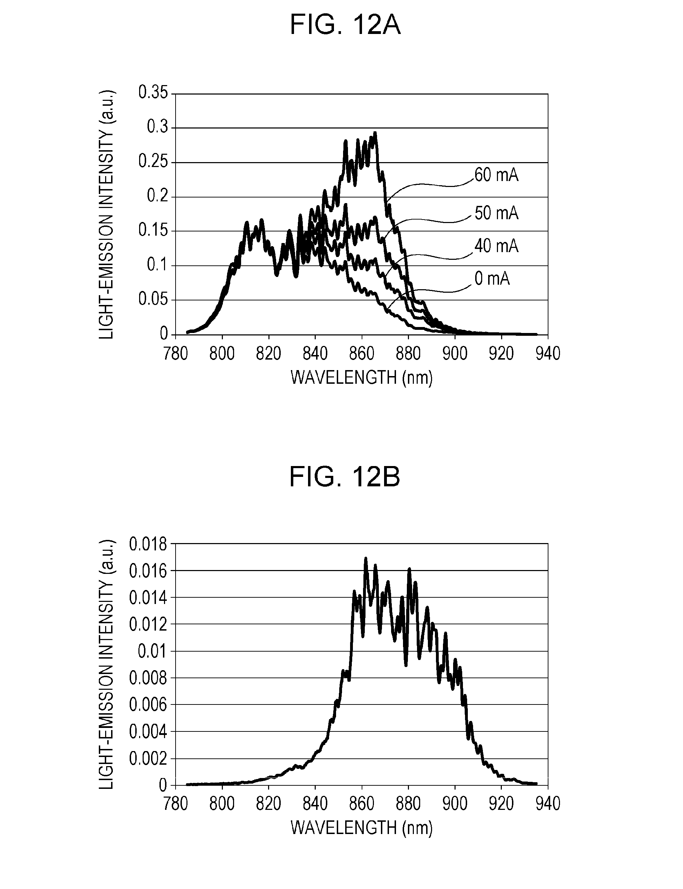

The active layer of Example 3 has a quantum well structure of InGaAs/AlGaAs. The length L₁ of the first electrode is 0.5 mm, and the length L₂ of the second electrode is 1.2 mm. A variation in emission spectrum in the case where the current to be injected into the second electrode is increased from 0 mA to 60 mA in a state in which a current of 225 mA is injected into the first electrode is illustrated in Fig. 12A.

Fig. 12B illustrates a spectrum when a single electrode SLD with an electrode having a length of 1.2 mm is driven at a 60 mA. The current value 225 mA to be injected into the first electrode corresponds to a state of driving at a current density in which emission of light is the strongest at levels on the short wavelength side other than levels on the most long wavelength side from among the light-emitting levels of the quantum well (one or more) which constitute part of the active layer.

According to Fig. 12B, the maximum value of the light-emission intensity is on the order of 0.015. In contrast, according to Fig. 12A, it is understood that the maximum value of the light-emission intensity in the case where a current of 60 mA is injected into the second electrode is on the order of 0.3, which is more than 10 times. In addition, it is also understood that the variation in the emission spectrum by injecting the current into the second electrode is such that the peak near 860 nm is increased, and increase and decrease of the spectrum to an end of the short wavelength and to an end of the long wavelength side of the emission spectrum is small. In other words, by controlling the injection current density to be injected into the second electrode, the light intensity near 860 nm may be selectively controlled, and the light intensity near 860 nm may be adjusted in the spectrum width determined by the first electrode. In this manner, the present inventors have found that only a certain part of the spectrum may be increased and decreased while restraining the influence on other portions of the spectrum by increasing and decreasing the injection current density to the second electrode in the light-emitting element of the above-described configuration and the driving conditions. As characteristics of the driving method for increasing and decreasing only a certain part on the spectrum as described above, the current density to be injected into the second electrode is smaller than the current density to be injected into the first electrode. For example, in the above-described example, the current density of the second electrode is 1/9 of that of the first electrode even during the injection of 60 mA. In this manner, even at the low current density, it stays in a state of driving the first electrode at a current density in which emission of light is the strongest at levels on the short wavelength side other than levels on the most long wavelength side from among the light-emitting levels of the quantum well (one or more) which constitute part of the active layer as described above. Therefore, the light guided from the second electrode to the first electrode causes the stimulated amplification in the first electrode, which achieves a large light output. In contrast, when the second electrode is driven, for example, at a current density of 50% or higher of the first electrode, the effect as the function of adjusting the light output as described above is reduced because light on the shorter wavelength side produces a larger output even at the second electrode. The method of driving the first and second electrodes described above has a structure using a relationship between the carrier density of the quantum well and the gain spectrum (the wavelength dependency of the gain). Therefore, even with the configuration other than the SLD having one quantum well used in the above-described experiments, for example, even with the light-emitting element including a plurality of the quantum wells used in the examples described above, an effect is brought about.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. A light source system (160) includes a laminate having a lower electrode layer (120), an active layer (103) and an upper electrode layer (120) in this order, a light-emitting element (100) including at least one of the upper electrode layer and the lower electrode layer divided into a plurality of electrodes and configured to emit light by injecting a current into the active layer via the upper electrode layer and the lower electrode layer, and a control unit (150) configured to control a current injecting amount to the upper electrode layer and the lower electrode layer. The control unit controls a half-value width of the emission spectrum of the light-emitting element by varying a difference between an injection current density to a first electrode (111) and an injection current density to a second electrode (112) among the plurality of electrodes.

## Claims

1. A light source system (160) comprising:
a laminate having a lower electrode layer (110), an active layer (103), and an upper electrode layer (120) in this order;
the laminate having a waveguide structure (105) in which light is guided in a direction perpendicular to a direction of lamination of the layers which constitute part of the laminate;
at least one of the upper electrode layer (110) and the lower electrode layer (120) being divided into a plurality of electrodes arranged in a direction in which the light is guided by the waveguide structure (105);
a light-emitting element (100) configured to emit light in the direction in which the light is guided by injecting an electric current into the active layer (103) via the upper electrode layer (110) and the lower electrode layer (120) and causing the active layer (103) to emit light; and
a control unit (150) configured to control a current injecting amount to the lower electrode layer (120) and the upper electrode layer (110), wherein
the control unit (150) is configured to control a half-value width of an emission spectrum of the light-emitting element (100)
by varying a difference between an injection current density to a first electrode (111) and an injection current density to a second electrode (112) different from the first electrode (111) among the plurality of electrodes.

2. The light source system according to Claim 1, wherein the control unit is configured to control the current injecting amount so that a half-value width of the emission spectrum of the light-emitting element varies by switching between a first mode in which a current is injected at an injection current density J₁ into the first electrode from among the plurality of electrodes and a current is injected into the second electrode at an injection current density J₂ smaller than J₁ and a second mode in which a current J₁', which is an injection current density smaller than J₁, is injected into the first electrode and a current J₂' which is an injection current density larger than J₂ and smaller than J₁' into the second electrode.

3. The light source system according to Claim 1 or 2, wherein a variation range of an output light intensity of the light-emitting element is 20% or smaller when the mode is changed from the first mode to the second mode.

4. The light source system according to any one of Claims 1 to 3, wherein the variation range of the output light intensity of the light-emitting element is 10% or smaller when the mode is changed from the first mode to the second mode.

5. The light source system according to any one of Claims 1 to 4, wherein the active layer has a quantum well structure.

6. The light source system according to any one of Claims 1 to 5, wherein the quantum well structure has a plurality of different quantum well structures.

7. The light source system according to any one of Claims 1 to 6, wherein at least one of the upper electrode layer and the lower electrode layer is divided into four of the electrodes.

8. The light source system according to any one of Claims 1 to 7, wherein
the control unit is configured to control the current injecting amount such that no current is injected into at least one of the plurality of electrodes.

9. The light source system according to any one of Claims 1 to 8, wherein the waveguide structure includes a ridge-type waveguide structure.

10. The light source system according to Claim 9, wherein the ridge-type waveguide structure is inclined into an in-plane direction of the active layer with respect to a perpendicular line of an outgoing end surface.

11. The light source system according to any one of Claims 1 to 10, further comprising an outgoing light detecting unit configured to detect a light intensity outgoing from the light-emitting element,
wherein the control unit is configured to control the current injecting amount based on the intensity of light detected by the outgoing light detecting unit.

12. An optical coherence tomography apparatus comprising:
the light source system (160) according to any one of Claims 1 to 11;
an interference optical system (102) configured to branch light from the light source system (160) into reference light and illumination to be radiated on an object (410), and to cause interference between the reference light and reflected light of the light radiated on the object (410) to generate interference light;
a spectroscope configured to branch the interference light;
an interference light detecting unit (404) configured to receive the branched interference light; and
an information obtaining unit (405) configured to obtain information on the object on the basis of the intensity of the branched interference light.
